(19) Europäisches Patentamt
European Patent Office
Office européen des brevets

(11) EP 3 080 554 B1

(12) EUROPÄISCHE PATENTSCHRIFT

(45) Veröffentlichungstag und Bekanntmachung des Hinweises auf die Patenterteilung:
14.08.2019 Patentblatt 2019/33

(51) Int Cl.:
*H03K 17/975* (2006.01)　　*H03K 17/96* (2006.01)

(21) Anmeldenummer: 14809391.7

(22) Anmeldetag: 09.12.2014

(86) Internationale Anmeldenummer:
PCT/EP2014/076989

(87) Internationale Veröffentlichungsnummer:
WO 2015/086568 (18.06.2015 Gazette 2015/24)

(54) BEDIENEINRICHTUNG FÜR EIN ELEKTRISCHES GERÄT, INSBESONDERE FÜR EINE FAHRZEUGKOMPONENTE

OPERATING DEVICE FOR AN ITEM OF ELECTRICAL EQUIPMENT, IN PARTICULAR FOR A VEHICLE COMPONENT

DISPOSITIF DE COMMANDE POUR UN APPAREIL ÉLECTRIQUE, EN PARTICULIER POUR UN COMPOSANT DE VÉHICULE À MOTEUR

(84) Benannte Vertragsstaaten:
AL AT BE BG CH CY CZ DE DK EE ES FI FR GB GR HR HU IE IS IT LI LT LU LV MC MK MT NL NO PL PT RO RS SE SI SK SM TR

(30) Priorität: 10.12.2013 DE 102013225436

(43) Veröffentlichungstag der Anmeldung:
19.10.2016 Patentblatt 2016/42

(73) Patentinhaber: Behr-Hella Thermocontrol GmbH
70469 Stuttgart (DE)

(72) Erfinder:
• FUST, Winfried
59556 Lippstadt (DE)
• MARQUAS, Karsten
59757 Arnsberg (DE)

(74) Vertreter: dompatent von Kreisler Selting Werner - Partnerschaft von Patent- und Rechtsanwälten mbB
Deichmannhaus am Dom
Bahnhofsvorplatz 1
50667 Köln (DE)

(56) Entgegenhaltungen:
EP-A1- 0 759 628　　WO-A1-2008/145477
DE-A1-102011 089 693　　US-B1- 6 675 656

**Beschreibung**

Die Erfindung betrifft eine Bedieneinrichtung für ein elektrisches Gerät oder eine Anlage, wobei die Bedieneinrichtung insbesondere für eine Fahrzeugkomponente vorgesehen ist.

Bedieneinrichtungen mit unterschiedlichst gestalteten Bedienelementen sind grundsätzlich bekannt. Dabei haben sich insbesondere im Automotive-Bereich Bedienkonzepte durchgesetzt, bei denen als Tasten ausgebildete Bedienelemente eingesetzt werden. In letzter Zeit wird zunehmend gefordert, dass derartige Tasten-Bedienelemente so auszulegen sind, dass sich ihre Oberflächen bei einer Betätigung für den Benutzer möglichst nicht wahrnehmbar bewegen sollten. Möglichst kleine Bewegungshübe sollen also realisiert und auch detektiert werden können. Über den zurückgelegten Weg kann dann ermittelt werden, ob das betreffende Bedienelement vorschriftsmäßig betätigt wurde; daraufhin wird dann die mit dem Bedienelement verbundene Funktion des Geräts bzw. der Anlage ausgelöst.

Ist bei einem derartigen System dessen Nachgiebigkeit (Steifigkeit) bekannt, kann aus der detektierten Verschiebung/Bewegung des Bedienelements aus seiner Ruhelage auf die Betätigungskraft geschlossen werden. Bei einer hohen Systemsteifigkeit ist die Verschiebung relativ gering (was letztendlich mitunter gewollt ist); somit stellt sich dann die Aufgabe, geringe Verschiebungen zuverlässig messen zu können. In DE-A-10 2011 089 693 ist eine Bedienvorrichtung beschrieben, bei der beim Niederdrücken eines in einer Leiterkarte intrigierten, freigeschnittenen Biegebalkens verformt wird. Der Biegebalken trägt an seinem nicht starr an die Leiterkarte angebundenen und damit freien Ende eine Kondensator-Elektrode, die mit einer an dem dem freien Ende des Biegebalkens zugewandten starren Leiterkartenbereich und damit lateral zum freien Ende angeordneten, weiteren Kondensator-Elektrode einen Kondensator bildet. Die Veränderung der Kapazität dieses Kondensators wird zur Detektion der Betätigung des Bedienelements und zur Wegdetektion genutzt.

DE-A-10 2013 100 649 zeigt ein Touch-Bedienelement mit taktiler Rückmeldung einer Berührung des Bedienelements. Hierbei wird ein Kondensator aufgebaut, dessen starre Elektrodenflächen verschoben und somit die Kapazität verändert wird.

Aufgabe der Erfindung ist es also, eine Bedieneinrichtung für ein elektrisches Gerät oder eine Anlage, insbesondere für eine Fahrzeugkomponente, zu schaffen, bei dem trotz möglichst geringer Bewegungshübe eines Bedienelements zuverlässig auf die Betätigung dieses Bedienelements geschlossen werden kann.

Zur Lösung dieser Aufgabe wird mit der Erfindung eine Bedieneinrichtung für ein elektrisches Gerät oder eine Anlage, insbesondere für eine Fahrzeugkomponente, vorgeschlagen, wobei die Bedieneinrichtung versehen ist mit

- mindestens einem elastisch gelagerten Bedienelement,
- einem Gegenelement, relativ zu dem das mindestens eine Bedienelement bei einer Betätigung unter Veränderung des Abstandes, und zwar in Bewegungsrichtung betrachtet, bewegbar ist,
- mindestens einem Kondensator, der einen ersten Trägerkörper mit einer ersten Kondensator-Elektrode und einen als Biegebalken ausgebildeten, elastisch verbiegbaren, zweiten Trägerkörper mit einer zweiten Kondensator-Elektrode aufweist,
- wobei die beiden Trägerkörper und die beiden Kondensator-Elektroden in Bewegungsrichtung des Bedienelements betrachtet übereinanderliegend angeordnet sind,
- wobei

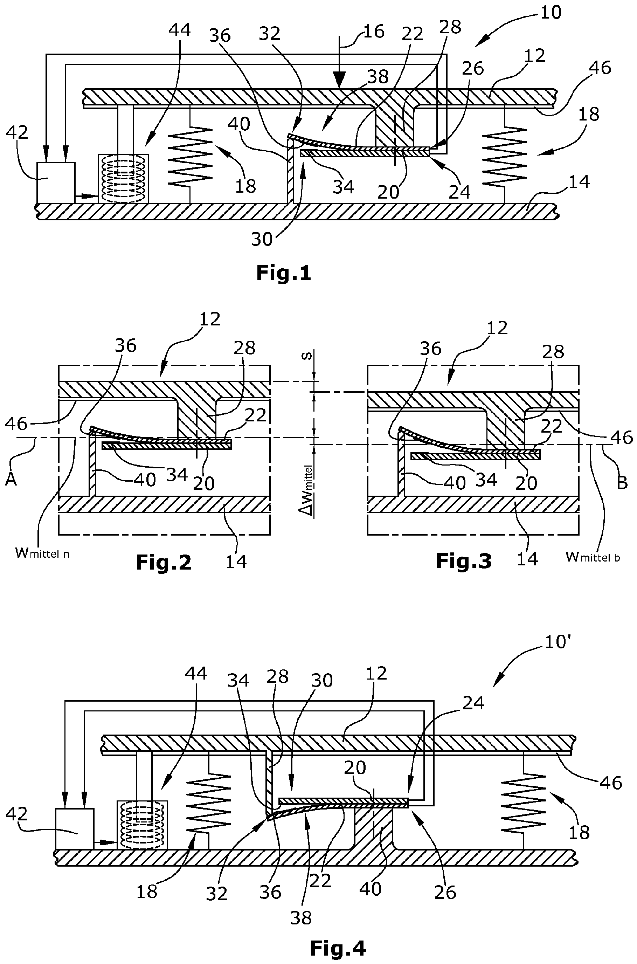

  - der Kondensator an dem mindestens einen Bedienelement gehalten und mit diesem bei dessen Betätigung mitbewegbar ist, indem die beiden Trägerkörper mit jeweils einem ersten Ende an dem mindestens einen Bedienelement befestigt sind und jeweils ein dem betroffenen ersten Ende gegenüberliegendes zweites Ende aufweisen, und der zweite Trägerkörper in Wirkverbindung mit dem Gegenelement steht, und zwar zur bei Betätigung des mindestens einen Bedienelements erfolgenden Bewegung des zweiten Endes des elastisch biegbaren zweiten Trägerkörpers von dem ersten Trägerkörper weg (siehe z. B. Fig. 1, wonach der erste Trägerkörper und das erste Ende des elastisch biegbaren zweiten Trägerkörpers an dem mindestens einen Bedienelement zur Bewegung des ersten Trägerkörpers und des ersten Endes des elastisch biegbaren zweiten Trägerkörpers zusammen mit dem mindestens einen Bedienelement befestigt sind und das dem ersten Ende des elastisch biegbaren zweiten Trägerkörpers gegenüberliegende zweite Ende des zweiten Trägerkörpers an dem Gegenelement angeordnet bzw. von diesem bei Betätigung des mindestens einen Bedienelements gestützt/gehalten ist und sich bei Betätigung des mindestens einen Bedienelements von dem ersten Trägerkörper wegbewegt), oder
  - der Kondensator an dem Gegenelement gehalten ist, indem die beiden Trägerkörper mit jeweils einem ersten Ende an dem Gegenelement befestigt sind und jeweils ein dem betroffenen Ende ersten Ende gegenüberliegendes zweite Ende aufweisen, und der zweite Trägerkörper in Wirkverbindung mit dem mindestens einen Bedienelement steht, und zwar zur bei Betätigung des mindestens einen Bedienelements erfolgenden Bewegung des zweiten Endes des zweiten Trägerkörpers von dem zweiten Ende des ersten Trägerkörpers weg (siehe z. B. Fig. 4, wonach der erste Trägerkörper an dem Gegenelement gehalten sowie das mindestens eine Bedienelement relativ zu dem ersten Trägerkörper bewegbar ist und der elastisch biegbare zweite Trägerkörper an seinem ersten Ende an dem Gegenelement gehalten ist und an seinem dem ersten Ende gegenüberliegenden zweiten Ende in Wirkverbindung mit dem mindestens einen Bedienelement zur Bewegung des zweiten Endes des elastisch biegbaren zweiten Trägerkörpers bei Betätigung des mindestens einen Bedienelements von dem ersten Trägerkörper weg steht), und

- wobei das zweite Ende des elastisch biegbaren zweiten Trägerkörpers bei einer Betätigung des mindestens einen Bedienelements unter Entstehung eines Abstandes und/oder unter Vergrößerung des Abstandes zwischen der ersten und der zweiten Kondensator-Elektrode eine von dem ersten Trägerkörper weg gerichtete Verbiegung erfährt und
- einer mit der ersten und der zweiten Kondensator-Elektrode verbundenen Auswerteeinheit zur Ermittlung der Kapazität und/oder einer Veränderung der Kapazität des mindestens einen Kondensators bei Betätigung des mindestens einen Bedienelements.

Der mit der erfindungsgemäßen Bedieneinrichtung verfolgte Ansatz besteht darin, eine Verschiebung des Bedienelements kapazitiv zu ermitteln, indem die Veränderung der Kapazität eines Kondensators mit einer elastischen Elektrode messtechnisch erfasst wird. Dabei besteht die Besonderheit darin, dass der Kondensator seine Kapazität bei der Bewegung eines Bedienelements aus seiner Ruhelage von hohen Werten auf geringere Werte verändert. Mithin "öffnet" sich der Kondensator, wenn das Bedienelement betätigt wird.

Nach der Erfindung weist die Bedieneinrichtung mindestens ein elastisch gelagertes Bedienelement auf. Dieses Bedienelement ist im Regelfall als Tastenkörper ausgebildet und lässt sich translatorisch bewegen; aber auch Durchbiegungen des Bedienelements können mit dem erfindungsgemäßen Konzept messtechnisch erfasst werden. Das Bedienelement wird in Richtung auf ein Gegenelement bewegt, wenn es betätigt wird, bzw. das Bedienelement bewegt sich von diesem Gegenelement wieder zurück, wenn auf das Bedienelement keine Betätigungskraft mehr ausgeübt wird.

Zwischen Bedienelement und Gegenelement befindet sich im Bewegungspfad ein Kondensator mit einem ersten und einem zweiten Trägerkörper, wobei jeder Trägerkörper eine (nachfolgend mit erste bzw. zweite bezeichnete) Kondensator-Elektrode aufweist. Während der erste Trägerkörper starr ausgebildet sein kann, ist der zweite Trägerkörper nach Art eines Biegebalkens ausgebildet und damit elastisch verbiegbar. Die beiden Kondensator-Elektroden liegen einander gegenüber.

Bei einer Betätigung des Bedienelements verbiegt sich der zweite Trägerkörper in zunehmendem Maße. Damit vergrößert sich der Abstand zwischen den beiden Kondensator-Elektroden, der bei sich in Ruhelage befindendem Bedienelement möglichst klein sein sollte. Damit nämlich weist der Kondensator im Ruhezustand des Bedienelements eine vergleichsweise große elektrische Kapazität auf, die verhältnismäßig schnell abnimmt, und zwar auch dann, wenn das Bedienelement nur minimal bewegt wird. Dieser vergleichsweise große Abfall der elektrischen Kapazität des Kondensators kann zuverlässig dazu genutzt werden, eine Betätigung des Bedienelements bzw. den Verschiebeweg des Bedienelements und damit (bei bekannter Steifigkeit des Systems) die Betätigungskraft zu ermitteln.

Sind aufgrund des Aufbaus und dessen Toleranzen Mindestabstände zwischen den Elektroden einzuhalten, was in der Regel einen Luftspalt zur Folge hat, der die Kapazität des Kondensators reduziert, so hat diese Erfindung den Vorteil, dass nur an einer Seite, nämlich der sich öffnenden Seite, dieser Mindestabstand eingehalten werden muss. Auf der gegenüberliegenden Seite kann der Luftspalt entfallen, so dass die Kapazität des Kondensators groß ist.

Das zuvor genannte Konzept der erfindungsgemäßen Bedieneinrichtung lässt sich gemäß einer ersten Alternative beispielsweise dadurch realisieren, dass der erste Trägerkörper relativ zum Bedienelement unbeweglich gehalten und das mindestens eine Bedienelement relativ zu dem zweiten Trägerkörper bewegbar und dieser elastisch biegbare zweite Trägerkörper an seinem ersten Ende an dem Bedienelement gehalten ist und an seinem dem ersten Ende gegenüberliegenden zweiten Ende bei Betätigung des Bedienelements erfolgender Bewegung des elastisch biegbaren zweiten Trägerkörpers in Wirkverbindung mit dem Gegenelement steht. Bei dieser Variante sind der erste Trägerkörper und das erste Ende des elastisch biegbaren zweiten Trägerkörpers an dem mindestens einen Bedienelement befestigt, so dass sie sich beide bei einer Betätigung des Bedienelements mit diesem mit bewegen. Das zweite Ende des elastisch biegbaren zweiten Trägerkörpers liegt dabei an dem Gegenelement an. Die beiden Trägerkörper liegen übereinander, wobei der elastisch biegbare zweite Trägerkörper zwischen dem Bedienelement und dem ersten Trägerkörper angeordnet ist. Somit verbiegt sich der zweite Trägerkörper umso mehr, je weiter das Bedienelement bewegt wird.

Bei einer zweiten Variante der erfindungsgemäßen Bedieneinrichtung ist vorgesehen, dass der erste Trägerkörper und das erste Ende des elastisch biegbaren zweiten Trägerkörpers an dem Gegenelement gehalten sind. Das zweite Ende des elastisch biegbaren zweiten Trägerkörpers steht in Wirkverbindung mit dem mindestens einen Bedienelement bei dessen Betätigung. Bei dieser Variante liegen die beiden Trägerkörper ebenfalls aufeinander, sind aber am Gegenelement gehalten. Das zweite Ende des elastisch biegbaren zweiten Trägerkörpers liegt, bezogen auf die Bewegungsrichtung des Bedienelements bei einer Betätigung, hinter dem ersten Trägerkörper und überdies mit seinem zweiten Ende am Betätigungselement an. Bei einer Betätigung des Bedienelements verbiegt sich wiederum der zweite Trägerkörper in zunehmendem Maße.

Für beide Varianten der Erfindung gilt also, dass das zweite Ende des elastisch biegbaren zweiten Trägerkörpers bei einer Betätigung des mindestens einen Bedienelements unter Entstehung eines Abstandes und/oder unter Vergrößerung des Abstandes zwischen der ersten und der zweiten Kondensator-Elektrode eine von dem ersten Trägerkörper weg gerichtete Verbiegung erfährt. Mittels einer mit der ersten und der zweiten Kondensator-Elektrode verbundenen Auswerteeinheit kann nun die Kapazität und/oder einer Veränderung der Kapazität des mindestens einen Kondensators bei Betätigung des mindestens einen Bedienelements ermittelt werden.

In weiterer vorteilhafter Ausgestaltung der Erfindung kann eine auf das mindestens eines Bedienelement einwirkende Rückmeldeeinheit zur Erzeugung einer taktilen Bestätigung einer Betätigung des mindestens einen Bedienelements vorgesehen sein, wobei die Rückmeldeeinheit in Abhängigkeit von der Größe der Kapazität oder dem Grad der Änderung der Kapazität, die bzw. den der Kondensator bei einer Betätigung des mindestens einen Bedienelements annimmt bzw. erfährt, ansteuerbar ist. Diese Rückmeldung kann auch akustisch oder optisch und ggf. auch in Kombination akustisch und optisch sowie, falls gewünscht, auch zusätzlich noch in Kombination mit einer taktilen Rückmeldung erfolgen. Eine taktile Rückmeldeeinheit lässt sich z.B. als Elektromagnet, dessen Anker am Bedienelement und dessen Spule mit Joch am Gehäuse - oder umgekehrt - befestigen lassen, oder als Unwuchtmotor oder Vibrationseinheit ausbilden.

Auf dem mindestens einen elastisch gelagerten Bedienelement der erfindungsgemäßen Bedieneinrichtung können mehrere Bedienfelder mit jeweils einem Symbol angeordnet sein. Unabhängig davon, welches Bedienfeld gerade mit beispielsweise dem Finger einer Hand zur Betätigung des Bedienelements kontaktiert und damit das Bedienelement betätigt wird, vollführt das Bedienelement eine Bewegung, die, wie oben beschrieben, erfindungsgemäß kapazitiv erfasst wird. Um nun zu ermitteln, auf welches Bedienfeld der Finger einer Hand bei einer Betätigung des Bedienelements einwirkt, ist die Verwendung einer kapazitiven Berührungssensorik von Vorteil, deren Auswertung insbesondere in der Auswerteeinheit erfolgt.

Die Erfindung wird nachfolgend anhand zweier Ausführungsbeispiele und mit Bezugnahme auf die Zeichnung näher erläutert. Im Einzelnen zeigen dabei:

Fig. 1      schematisch den Aufbau der bewegbaren Lagerung eines Bedienelements mit kapazitiver Ermittlung einer Betätigung gemäß einem ersten Ausführungsbeispiel,

Fign. 2 und 3      Ausschnitte des Bedienelementkonzepts gemäß Fig. 1 im Falle der Einnahme der Ruhelage des Bedienelements (siehe Fig. 2) und bei betätigtem Bedienelement (siehe Fig. 3) und

Fig. 4      schematisch den Aufbau der bewegbaren Lagerung eines Bedienelements mit kapazitiver Ermittlung einer Betätigung gemäß einem zweiten Ausführungsbeispiel.

In Fig. 1 ist ein erstes Ausführungsbeispiel einer Bedieneinrichtung 10 gezeigt. Diese Bedieneinrichtung 10 weist ein elastisch gelagertes Bedienelement 12 auf, das in Richtung auf ein Gegenelement 14 und von diesem weg bewegbar ist, wenn, wie in Fig. 1 bei 16 angedeutet, auf das Bedienelement 12 eine Betätigungskraft einwirkt bzw. diese Betätigungskraft wieder aufgehoben wird. Die elastische Lagerung des Bedienelements 12 ist in Fig. 1 schematisch durch die Federn 18 repräsentiert.

An dem Bedienelement 12 sind ein insbesondere starrer erster Trägerkörper 20 sowie ein elastisch biegbarer zweiter Trägerkörper 22 übereinanderliegend befestigt. Bei dem ersten Trägerkörper 20 kann es sich beispielsweise um eine Leiterkarte handeln, während der zweite Trägerkörper 22 als Blechstreifen ausgebildet sein kann. Wie anhand von Fig. 1 zu erkennen ist, sind die beiden Trägerkörper 20, 22 im Bereich ihrer ersten Enden 24, 26 an einem Vorsprung 28 des ansonsten plattenförmigen Bedienelements 12 befestigt. Der Vorsprung 28 weist in Richtung auf das Gegenelement 14. Die beiden Trägerkörper 20, 22 weisen darüber hinaus ihren jeweiligen ersten Enden 24 bzw. 26 gegenüberliegende zweite Enden 30, 32 auf, wobei das Ende 32 des elastisch biegbaren zweiten Trägerkörpers 22 das zweite Ende 30 des ersten Trägerkörpers 20 überragt.

Im Bereich des zweiten Endes 30 des ersten Trägerkörpers 20 befindet sich eine erste Kondensatorelektrode 34. Dieser gegenüberliegend befindet sich ein Abschnitt des zweiten Trägerkörpers 22, der innerhalb dieses Abschnitts eine zweite Kondensatorelektrode 36 bildet. Mithin entsteht somit ein Kondensator 38 (mit elektrisch gegeneinander isolierten Elektroden).

Wie ferner in Fig. 1 zu erkennen ist, ruht das zweite Ende 32 des zweiten Trägerkörpers 22 auf einem Auslenkelement 40 des Gegenelements 14. Wird nun das Betätigungselement 12 gedrückt, also betätigt, verbiegt sich der zweite Trägerkörper 22 aufgrund der Anlage seines zweiten Endes 32 am Auslenkelement 40 zunehmend, was durch den Vergleich der Fign. 2 und 3 deutlich wird. In Fig. 2 ist die Situation der Kondensatorausbildung gezeigt, in der sich das Bedienelement 12 in seiner Ruheposition befindet. Fig. 3 zeigt den Fall, dass das Bedienelement 12 gedrückt und damit betätigt ist. Dies definiert den Betätigungshub s. Das Auslenkelement 40 muss nicht notwendigerweise am zweiten Ende 32 des zweiten Tragekörpers 32 anliegen sondern kann diesen auch an einer anderen Position berühren und auslenken, wobei das Auslenkelement 40 dazu durch eine Öffnung o.dgl. Aussparung durch den ersten Trägerkörper 20 ragt, um in Anlage mit dem zweiten Trägerkörper 22 zu gelangen.

Dieser Betätigungshub s kann nun aufgrund der sich verändernden Kapazität des Kondensators 38 ermittelt werden. In Fig. 2 ist bei "A" das Niveau des mittleren Elektrodenabstandes $w_{mittel\,n}$ bei sich in Ruhe- bzw. Normallage befindendem Bedienelement 12 eingezeichnet. In Fig. 3 ist bei "B" das Niveau des mittleren Kondensator-Elektroden-Abstandes $w_{mittel\,b}$ eingezeichnet, der sich einstellt, wenn das Bedienelement 12 betätigt ist. Die Differenz zwischen den beiden Niveaus "A" und "B" ist mit $\Delta w_{mittel}$ bezeichnet; zu erkennen ist, dass $\Delta w_{mittel}$ kleiner ist als der Hub s, was aber nach der Erfindung nicht zwingend erforderlich ist.

In Fig. 1 ist noch angedeutet, dass die beiden Kondensator-Elektroden 34, 36 elektrisch mit einer Auswerteeinheit 42 verbunden sind. In dieser Auswerteeinheit 42 erfolgt die Ermittlung der Kapazität bzw. der Kapazitätsveränderung bei Betätigung des Bedienelements 12. Als taktile Rückmeldung kann eine entsprechende Rückmeldeinheit 44 vorgesehen sein, die einen elektromechanischen Antrieb zum Versetzen des Bedienelements 12 in Vibrationen aufweist.

In Fig. 4 ist ein zum Betätigungsermittlungskonzept nach Fig. 1 inverses Konzept gezeigt. Bei der diesbezüglichen Bedieneinrichtung 10' der Fig. 4 bewegt sich also der Kondensator 38 bzw. bewegen sich die übereinander angeordneten Trägerkörper 20 und 22 nicht mit dem Bedienelement 12 mit, wenn dieses betätigt wird (ausgenommen davon ist die Verbiegung des elastisch biegbaren zweiten Trägerkörpers 22). Im Übrigen gilt für Fig. 4, dass dort diejenigen Elemente, die konstruktions- bzw. funktionsgleich zu den Elementen der Bedieneinrichtung 10 nach Fig. 1 sind, mit den gleichen Bezugszeichen wie in den Fign. 1 bis 3 bezeichnet sind.

Wie sich aus dem Vorstehenden ergibt, kann also erfindungsgemäß mit verhältnismäßig einfachen Mitteln, nämlich mit einer Leiterkarte, einem Blechstreifen und einer Kapazitätsmesseinrichtung eine geringe Wegänderung messtechnisch erfasst werden. Dabei wird lediglich gefordert, dass eines der beiden Elemente "Leiterkarte" und "Blechstreifen" sich gegenüber dem anderen mit einer bekannten Steifigkeit verschieben lässt.

Kraftmessungen (bzw. deren Ermittlung), wie sie erfindungsgemäß möglich sind, treten zunehmend in Verbindung mit Touch-Bedienfunktionen auf. Daher kann die hierfür notwendige Hard- und Software mit genutzt werden. Verglichen mit bekannten kapazitiven Systemen ist die Kapazitätsänderung bezogen auf die Wegstrecke bei dem erfindungsgemäßen Ansatz aufgrund des physikalischen Prinzips, das sich die Erfindung zunutze macht, erheblich größer, was die Genauigkeit der Kraftbestimmung verbessert.

Zu den Merkmalen der Erfindung zählen insbesondere die folgenden, die sowohl einzeln als auch in beliebiger Kombination umsetzbar sind:

- Die Abnahme der Kapazität wird zur Wegmessung genutzt.

- In der Ausgangslage haben die beiden Platten des Kondensators einen geringeren Abstand.

- Eine starke kapazitive Änderung wird erreicht weil:

  - Der Abstand zwischen den Platten vergrößert wird und
  - ein zweites Dielektrikum, hier Luft, in den Spalt zwischen den Kondensatorplatten eindringt.

- Eine Kondensatorplatte ist elastisch.

- Der Luftspalt zwischen den Kondensatorplatten wird durch die Biegung der elastischen Kondensatorplatte gebildet, z.B. ein Blech. Hierdurch wird eine mechanische Übersetzung zwischen der mechanischen Verschiebung des Gesamtsystems und der tatsächlichen mittleren Abstandsänderung im Kondensator erreicht.

- Toleranzen der Bauteile werden durch die Elastizität des Kondensatorbleches ausgeglichen; durch diesen Ausgleich der Toleranzen wird ein Leerhub der Taste vermieden, und somit können kleinste Bewegungen innerhalb der Messgenauigkeit erfasst werden.

Ganz grundsätzlich sei nachfolgend nochmals auf die physikalischen/elektrotechnischen Grundlagen des erfindungsgemäßen Ansatzes eingegangen.

Das lediglich minimal verschiebbare Bedienelement, dessen Verschiebung messtechnisch erfasst werden soll, ist elastisch mit einem anderen Bauteil, beispielsweise mit einem Gehäuse oder, wie oben ausgedrückt, einem Gegenelement verbunden. Die Steifigkeit dieser Verbindung (in den Figuren durch die Federn 18 repräsentiert) ist bekannt. Über den Kraft/Weg-Zusammenhang, nämlich

$$F = D \times s,$$

mit D der Steifigkeit und s dem Weg kann mit Hilfe der Verschiebung S auf die ausgeübte Kraft F zurückgerechnet werden.

Der Kondensator zur Wegmessung weist eine ebene Kondensatorplatte, z.B. ein Kupferpad auf einer Leiterkarte, auf. Diese Leiterkarte nimmt auch die Elektronik zur Messung der Kapazität auf. Elektrisch isoliert, gegenüber der ersten Kondensatorplatte, liegt z.B. ein Blechstreifen, der die zweite Kondensatorplatte bildet. Die Kapazität des Kondensators berechnet sich nach:

$$C = \varepsilon_0 \times \varepsilon_r \times A / w,$$

mit $\varepsilon_0$ als elektrische Feldkonstante, $\varepsilon_r$ als relative Permeabilität des Materials im Spalt (im Regelfall Luft), A der Fläche des Kondensators und w dem Abstand der Kondensatorplatten. Wird nun eine Kraft auf das Bedienelement ausgeübt, so wird über die elastische Verformung der Federn der Weg s zurückgelegt. Somit verschiebt sich der (aufragende Betätigungs-)Zapfen gegenüber der Leiterkarte mit dem Kupferpad und dem Blechstreifen. Hierdurch wird der Blechstreifen vom Kupferpad abgehoben. Aufgrund der einseitigen festen Einspannung verformt sich das Blech entsprechend und bildet eine Biegelinie aus (siehe Fign. 1 bis 4). Der Spalt zwischen dem Kupferpad auf der Leiterkarte und dem Blechstreifen hat nun eine Höhe, die vom Ort auf dem Blechstreifen abhängig ist (siehe Fign. 2 und 3). Wird nun ein mittlerer Abstand vor und nach der Verschiebung ermittelt, ist dieser Abstand geringer als die Verschiebung s des Bedienelementes. Somit findet aufgrund der Biegelinie eine Übersetzung der Verschiebung s in den mittleren Abstand w des Kondensators statt (siehe Fign. 2 und 3).

Da sich der Kondensator mit zunehmendem Weg s weiter öffnet, d.h. der Blechstreifen weiter von der Leiterkarte weggebogen, werden keine Betätigungskräfte auf die Leiterkarte übertragen, was diese vor Beschädigung schützt.

Wird die Wegmessung mit einer haptischen Rückmeldung kombiniert, die in Richtung der Betätigung wirkt, öffnet dieser weitere Weg des Bedienelementes zur haptischen Rückmeldung den Kondensator zusätzlich (siehe die Fign. 1 bis 4).

Anders als bei Systemen, die mit "sich schließenden" Kondensatoren und damit mit sich vergrößernder Kapazität arbeiten, muss nach der Erfindung der Betätigungsweg für die Auslösung und ggf. Rückmeldung und damit als "Vorhalt" wie bei einem sich "schließenden" Kondensator nicht vorgesehen werden, so dass der Kondensatorspalt in der Ruheposition sehr klein ausgeführt werden kann, was eine hohe Ausgangskapazität zulässt.

In den Fign. 1 bis 4 ist bei 46 eine kapazitive Berührungssensorik angedeutet, mit der es möglich ist zu ermitteln, an welcher Stelle sich beispielsweise der Finger einer Hand befindet, wenn das Bedienelement 12 betätigt wird.

## BEZUGSZEICHENLISTE

10    Bedieneinrichtung
10'    Bedieneinrichtung
12    Bedienelement
14    Gegenelement
16    Betätigungskraft
18    Feder
20    Trägerkörper
22    Trägerkörper
24    erstes Ende des ersten Trägerkörpers
26    erstes Ende des zweiten Trägerkörpers
28    Vorsprung
30    zweites Ende des ersten Trägerkörpers
32    zweites Ende des zweiten Trägerkörpers
34    erste Kondensator-Elektrode
36    zweite Kondensator-Elektrode
38    Kondensator
40    Auslenkungselement für den zweiten Trägerkörper
42    Auswerteeinheit
44    Rückmeldeeinheit
46    Berührungssensorik
s    Betätigungshub
w    Abstand
F    Betätigungskraft

## Patentansprüche

1. Bedieneinrichtung für ein elektrisches Gerät, mit

- mindestens einem elastisch gelagerten Bedienelement (12,28),
- einem Gegenelement (14,40), relativ zu dem das mindestens eine Bedienelement (12,28) bei einer Betätigung unter Veränderung des Abstandes, und zwar in Bewegungsrichtung betrachtet, bewegbar ist,
- mindestens einem Kondensator (38), der einen ersten Trägerkörper (20) mit einer ersten Kondensator-Elektrode (34) und einen als Biegebalken ausgebildeten, elastisch biegbaren, zweiten Trägerkörper (22) mit einer zweiten Kondensator-Elektrode (36) aufweist,
- wobei die beiden Trägerkörper (20,22) und die beiden Kondensator-Elektroden (34,36) in Bewegungsrichtung des Bedienelements (12,28) betrachtet übereinanderliegend angeordnet sind,
- wobei

- der Kondensator (38) an dem mindestens einen Bedienelement (12,28) gehalten und mit diesem bei dessen Betätigung mitbewegbar ist, indem die beiden Trägerkörper (20,22) mit jeweils einem ersten Ende (24,26) an dem mindestens einen Bedienelement (12,28) befestigt sind und jeweils ein dem betroffenen ersten Ende (24,26) gegenüberliegendes zweites Ende (30,32) aufweisen, und der zweite Trägerkörper (22) in Wirkverbindung mit dem Gegenelement (14,40) steht, und zwar zur bei Betätigung des mindestens einen Bedienelements (12,28) erfolgenden Bewegung des zweiten Endes (32) des elastisch biegbaren zweiten Trägerkörpers (22) von dem zweiten Ende (30) des ersten Trägerkörpers (20) weg,

oder

- der Kondensator (38) an dem Gegenelement (14,40) gehalten ist, indem die beiden Trägerkörper (20,22) mit jeweils einem ersten Ende (24,26) an dem Gegenelement (14,40) befestigt sind und jeweils ein dem betroffenen ersten Ende (24,26) gegenüberliegendes zweites Ende (30,32) aufweisen, und der zweite Trägerkörper (22) in Wirkverbindung mit dem mindestens einen Bedienelement (12,28) steht, und zwar zur bei Betätigung des mindestens einen Bedienelements (12,28) erfolgenden Bewegung des zweiten Endes (32) des zweiten Trägerkörpers (22) von dem zweiten Ende (30) des ersten Trägerkörpers (20) weg und

- wobei das zweite Ende (32) des elastisch biegbaren zweiten Trägerkörpers (22) bei einer Betätigung des mindestens einen Bedienelements (12,28) unter Entstehung eines Abstandes und/oder unter Vergrößerung des Abstandes zwischen der ersten und der zweiten Kondensator-Elektrode (34, 36) eine von dem ersten Trägerkörper (20) weg gerichtete Verbiegung erfährt und

- einer mit der ersten und der zweiten Kondensator-Elektrode (34, 36) verbundenen Auswerteeinheit (42) zur Ermittlung der Kapazität und/oder einer Veränderung der Kapazität des mindestens einen Kondensators (38) bei Betätigung des mindestens einen Bedienelements (12,28).

2. Bedieneinrichtung nach Anspruch 1, **gekennzeichnet durch** eine auf das mindestens eines Bedienelement (12,28) einwirkende Rückmeldeeinheit (44) zur Erzeugung einer taktilen Bestätigung einer Betätigung des mindestens einen Bedienelements (12,28), wobei die Rückmeldeeinheit (44) in Abhängigkeit von der Größe der Kapazität, die der Kondensator (38) bei einer Betätigung des mindestens einen Bedienelements (12,28) annimmt, oder in Abhängigkeit von dem Grad der Änderung der Kapazität, den der Kondensator (38) bei einer Betätigung des mindestens einen Bedienelements (12,28) erfährt, ansteuerbar ist.

3. Bedieneinrichtung nach Anspruch 1 oder 2, **dadurch gekennzeichnet, dass** das mindestens eine Bedienelement (12,28) mehrere Symbole aufweisende Bedienfelder aufweist, wobei mittels einer kapazitiven Berührungssensorik (46) in der Auswerteeinheit (42) ermittelbar ist, welches Bedienfeld bei einer z.B. mittels eines Fingers einer Hand erfolgenden Betätigung des mindestens einen Bedienelements (12,28) kontaktiert ist.

4. Bedieneinrichtung nach einem der Ansprüche 1 bis 3, **dadurch gekennzeichnet, dass** am Bedienelement (12,28) oder am Gegenelement (14,40) ein Auslenkelement (40) angeordnet ist, an dem der zweite Trägerkörper (22) und insbesondere dessen zweites Ende (32) anliegt.

5. Bedieneinrichtung nach Anspruch 4, **dadurch gekennzeichnet, dass** das zweite Ende (32) des zweiten Tragekörpers (22) das zweite Ende (30) des ersten Trägerkörpers (20) überragt.

6. Bedieneinrichtung nach Anspruch 4, **dadurch gekennzeichnet, dass** das Auslenkelement (40) durch eine Öffnung des ersten Trägerkörpers (20) in Anlage-Wirkverbindung mit dem zweiten Trägerkörper (22) steht.

**Claims**

1. An operating device for an electrical apparatus, comprising

- at least one elastically mounted operating element (12,28),
- a counter-element (14,40), relative to which the at least one operating element (12,28) is movable when actuated, thereby causing a change of distance as seen in the movement direction,
- at least one capacitor (38) which comprises a first carrier body (20) with a first capacitor electrode (34) and comprises an elastically bendable second carrier body (22), designed as a bending bar, with a second capacitor electrode (36),
- wherein the two carrier bodies (20,22) and the two capacitor electrodes (34,36) are arranged above each other when seen in the moving direction of the operating element (12,28),
- wherein

- the capacitor (38) is held on the at least one operating element (12,28) and upon actuation of the operating element can be moved along with the operating element in that the two carrier bodies (20,22) are fastened by their first ends (24,26) to the at least one operating element (12,28), and respectively have a second end (30,32) opposite to the respective first end (24,26), and the second carrier body (22) is in operative connection with the counter-element (14,40), for movement of the second end (32) of the elastically bendable second carrier body (22) away from the second end (30) of the first carrier body (20), upon actuation of the at least one operating element (12,28),

or

- the capacitor (38) is held on the counter-element (14,40) in that the two carrier bodies (20,22) are fastened by their first ends (24,26) to the counter-element (14,40), and respectively have a second end (30,32) opposite to the respective first end (24,26), and the second carrier body (22) is in operative connection with the at least one operating element (12,28), notably for movement of the second end (32) of the second carrier body (22) away from the second end (30) of the first carrier body (20), upon actuation of the at least one operating element (12,28),

- wherein the second end (32) of the elastically bendable second carrier body (22) undergoes a deflection oriented away from the first carrier body (20), upon actuation of the at least one operating element (12,28) and a resultant generation and/or enlargement of the distance between the first and second capacitor electrodes (34,36) and

- an evaluation unit (42) connected to the first and second capacitor electrodes (34,36) for determining the capacitance and/or a change of the capacitance of the at least one capacitor (38), upon actuation of at least one operating element (12,28).

2. The operating device according to claim 1, **characterized by** a feedback unit (44) acting on the at least one operating element (12,28) for generating a tactile confirmation of an actuation of the at least one operating element (12,28), wherein said feedback unit (44) is adapted to be controlled depending on the amount of the capacitance that the capacitor (38) undergoes upon actuation of at least one operating element (12,28), or depending on the degree of the change of capacitance that the capacitor (38) undergoes upon actuation of the at least one operating element (12,28).

3. The operating device according to claim 1 or 2, **characterized in that** the at least one operating element (12,28) comprises operating fields including a plurality of symbols, wherein, by means of a capacitive touch sensor arrangement (46), it can be detected in the evaluation unit (42) which one of the operating fields is contacted during actuation of the at least one operating element (12,28) performed e.g. by a finger of a hand.

4. The operating device according to any one of claims 1 to 3, **characterized in that**, on the operating element (12,28) or on the counter-element (14,40), a deflection element (40) is arranged which has the second carrier body (22) abutting on it, particularly by the second end (32) of the second carrier body.

5. The operating device according to claim 4, **characterized in that** the second end (32) of the second carrier body (22) extends beyond the second end (30) of the first carrier body (20).

6. The operating device according to claim 4, **characterized in that** said deflection element (40) via an opening of the first carrier body (20) is in abutting operative connection with the second carrier body (22).

**Revendications**

1. Dispositif de commande pour un appareil électrique, doté

- d'au moins un élément de commande (12, 28) disposé de manière élastique,
- d'un élément complémentaire (14, 40) relativement auquel l'au moins un élément de commande (12, 28) est mobile lors d'un actionnement avec variation de l'écart, à savoir vu dans le sens du mouvement,
- d'au moins un condensateur (38), lequel comporte un premier corps porteur (20) avec une première électrode de condensateur (34) et un deuxième corps porteur (22) élastiquement flexible, réalisé comme poutre de flexion, avec une deuxième électrode de condensateur (36),
- dans lequel les deux corps porteurs (20, 22) et les deux électrodes de condensateur (34, 36) sont agencés en superposition vus dans le sens du mouvement de l'élément de commande (12, 28),
- dans lequel

o le condensateur (38) est maintenu sur l'au moins un élément de commande (12, 28) et est co-mobile avec celui-ci lors de son actionnement, les deux corps porteurs (20, 22) étant fixés respectivement avec une première extrémité (24, 26) sur l'au moins un élément de commande (12, 28) et comportant respectivement une deuxième extrémité (30, 32) opposée à la première extrémité concernée (24, 26), et le deuxième corps porteur (22) est raccordé de manière opérante à l'élément complémentaire (14, 40), à savoir pour le mouvement effectué de la deuxième extrémité (32) du deuxième corps porteur (22) élastiquement flexible l'éloignant de la deuxième extrémité (30) du premier corps porteur (20), lors de l'actionnement de l'au moins un élément de commande (12, 28),

ou

o le condensateur (38) est maintenu sur l'élément complémentaire (14, 40), les deux corps porteurs (20, 22) étant fixés respectivement avec une première extrémité sur l'élément complémentaire (14, 40) et comportant respectivement une deuxième extrémité (30, 32) opposée à la première extrémité concernée (24, 26), et le deuxième corps porteur (22) est raccordé de manière opérante à l'au moins un élément de commande (12, 28), à savoir pour le mouvement effectué de la deuxième extrémité (32) du deuxième corps porteur (22) l'éloignant de la deuxième extrémité (30) du premier corps porteur (20), lors de l'actionnement de l'au moins un élément de commande (12, 28) et

- dans lequel la deuxième extrémité (32) du deuxième corps porteur (22) élastiquement flexible subit une flexion l'éloignant du premier corps porteur (20), lors d'un actionnement de l'au moins un élément de commande (12, 28) avec apparition d'un écart et/ou élargissement de l'écart entre la première et la deuxième électrode de condensateur (34, 36) et
- d'une unité de traitement (42) raccordée à la première et à la deuxième électrode de condensateur (34, 36) destinée à déterminer la capacité et/ou une variation de la capacité de l'au moins un condensateur (38) lors de l'actionnement de l'au moins un élément de commande (12, 28).

2. Dispositif de commande selon la revendication 1, **caractérisé par** une unité de rétroaction (44) opérant sur l'au moins un élément de commande (12, 28) pour produire une confirmation tactile d'un actionnement de l'au moins un élément de commande (12, 28), dans lequel l'unité de rétroaction (44) est pilotable en fonction de la valeur de la capacité, que le condensateur (38) reçoit lors d'un actionnement de l'au moins un élément de commande (12, 28), ou en fonction du degré de variation de la capacité, que le condensateur (38) subit lors d'un actionnement de l'au moins un élément de commande (12, 28).

3. Dispositif de commande selon la revendication 1 ou 2, **caractérisé en ce que** l'au moins un élément de commande (12, 28) comporte plusieurs champs de commande comportant des symboles, dans lequel l'unité de traitement (42) peut déterminer, au moyen d'un système de capteurs de contact capacitifs (46), quel champ de commande est touché lors d'un actionnement de l'au moins un élément de commande (12, 28) s'effectuant par exemple au moyen d'un doigt d'une main.

4. Dispositif de commande selon l'une des revendications 1 à 3, **caractérisé en ce qu'**un élément de déviation (40), contigu au deuxième corps porteur (22) et en particulier à la deuxième extrémité (32) de celui-ci, est agencé à l'élément de commande (12, 28) ou à l'élément complémentaire (14, 40).

5. Dispositif de commande selon la revendication 4, **caractérisé en ce que** la deuxième extrémité (32) du deuxième corps porteur (22) dépasse la deuxième extrémité (30) du premier corps porteur (20).

6. Dispositif de commande selon la revendication 4, **caractérisé en ce que** l'élément de déviation (40) est installé et raccordé de manière opérante avec le deuxième corps porteur (22) à travers une ouverture du premier corps porteur (20).

**Fig.1**

**Fig.2**

**Fig.3**

**Fig.4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102011089693 A
- DE 102013100649 A